# EUROPEAN PATENT APPLICATION

(11) **EP 0 746 028 A2**
(43) Date of publication of application: **04.12.1996**
(21) Application number: 96303294.1
(22) Date of filing: 14.05.1996
(51) Int. Cl.: H01L 23/64

(54) **Integrated inductor arrangement**

(30) Priority: 01.06.1995 GB 9511060
(71) Applicant: PLESSEY SEMICONDUCTORS LIMITED, Swindon, Wiltshire SN2 2QW (GB)
(72) Inventor: Cooke, Michael Peter, Swindon, Wilts. SN4 8NB (GB)
(74) Representative: Hoste, Colin Francis

(57) **Abstract**

An integrated inductor arrangement comprises a first layer of a first doping type disposed on a second layer of a second doping type, a dielectric layer disposed on said first layer and a metallisation inductor structure disposed on said dielectric layer. A biasing means is provided to allow the reverse-biasing of said first layer with respect to said second layer, this reverse-biasing serving to increase the thickness of a depletion layer formed between the first and second layers. This increase in thickness reduces the overall parasitic capacitance seen by the inductor relative to the second layer and also reduces the magnitude of the currents induced in the first and second layers by the inductor structure. A further depletion layer may be provided in the first layer adjacent the dielectric layer, corresponding further biasing means being provided for the reverse-biasing of this layer with respect to the first layer. Normally, the first layer will be an epitaxial layer and the second layer will be a substrate.

## Description

The invention concerns an integrated inductor arrangement, and especially, but not exclusively, an integrated inductor arrangement incorporating an epitaxial substrate and intended for use in the design of RF integrated circuits using silicon-based transistors.

The implementation of inductors, and in particular planar inductors, on epitaxial substrates is becoming increasingly important in the design of RF integrated circuits using silicon-based transistors. Such inductors are used for on-chip filtering and matching and for on-chip VCO's (voltage-controlled oscillators).

The uses to which these inductors can be put are limited primarily by the Q-factor attainable. This in turn is limited by four parameters: the series resistance of the metallic inductor; the parasitic capacitance from the inductor to the substrate; the parasitic inter-turn capacitance, and ohmic energy losses due to currents induced in the conducting epitaxy and substrate.

The present invention aims to increase the available Q-factor by providing a reduction in two of the above-mentioned parameters, namely parasitic capacitance to the substrate and ohmic energy losses.

In accordance with the invention, there is provided an integrated inductor arrangement, comprising a first layer of a first doping type disposed on a second layer of a second doping type, a dielectric layer disposed on said first layer and a metallisation inductor structure disposed on said dielectric layer, a biasing means being provided to allow the reverse-biasing of said first layer with respect to said second layer.

Provision of the biasing means has the advantage of allowing the thickness of a depletion layer, which is formed between the first and second layers, to be varied such as to minimise the total parasitic capacitance existing between the inductor structure and the second layer and to reduce the currents induced in the first and second layers by the inductor structure during use.

A field oxide layer may be provided between said dielectric layer and said first layer.

The biasing means may comprise a first contact structure disposed in said dielectric layer adjacent said oxide layer and making electric contact with said first layer, and a second contact structure in electrical contact with said second layer. The first contact structure may advantageously be a high-impedance structure.

The inductor arrangement may comprise a further layer of said second doping type disposed in said first layer adjacent said oxide layer, a further biasing means being provided to allow the reverse-biasing of said further layer with respect to said first layer.

The further biasing means may comprise a third contact structure of said second doping type in electrical contact with a surface of said further layer adjacent said oxide layer. The third contact structure may advantageously be high-impedance. The further layer may be provided by means of a shallow implant or a deposition.

The first layer may be an epitaxial layer and the second layer may be a substrate layer.

An isolating structure may be provided for isolating the inductor structure from other circuitry on the substrate layer. The isolating structure may comprise a trench etched through said epitaxial layer into said substrate layer and disposed such as to enclose an area containing most of the fringing electric fields which are produced by the inductor stucture during use.

Embodiments of the invention will now be described, by way of non-limitative example, with reference to the drawings, of which:
Figure 1 is a plan view of an integrated inductor arrangement according to the present invention;
Figure 2 is a cross-sectional view through the line II-II of Figure 1;
Figure 3 is a simplified schematic diagram of an integrated-circuit package including an inductor arrangement according to the invention;
Figure 4 is an equivalent circuit for the integrated inductor arrangement of Figures 1 and 2, and
Figure 5 is a cross-sectional view of a second embodiment of the integrated inductor arrangement according to the invention.

It should be noted that the various figures are not to scale.

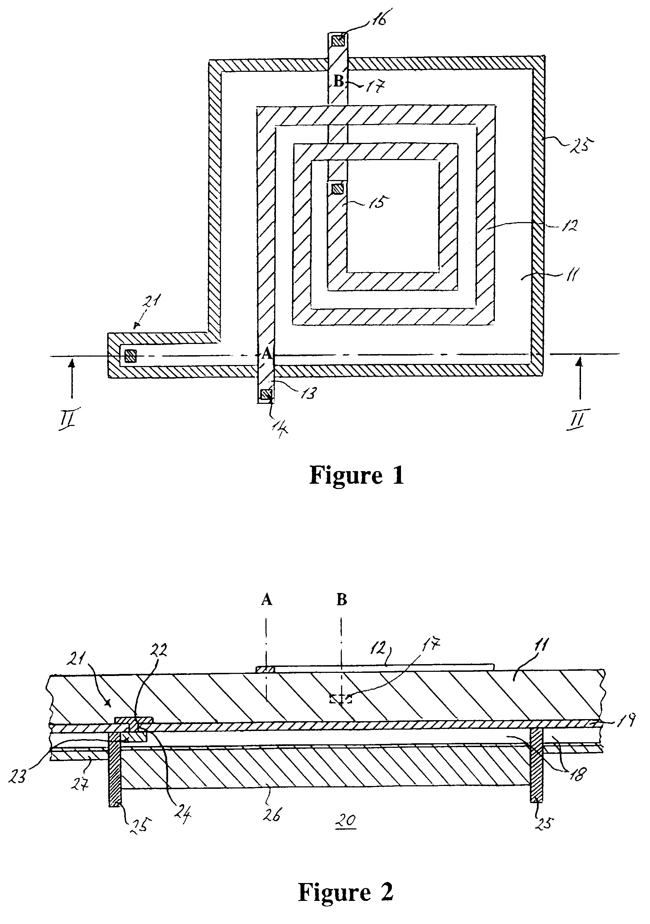

Referring first to Figures 1 and 2, an integrated inductor arrangement in accordance with the present invention comprises a dielectric layer 11 on which is configured a planar inductor metallisation structure 12. The outer end 13 of the inductor structure 12 is taken to a metal contact 14 while the inner end 15 of the structure 12 is taken to a metal contact 16 by way of an inner metallisation layer 17 disposed within the dielectric layer 11. The dielectric layer 11 is disposed on a lightly doped N-type epitaxial layer 18 (not shown hatched for reasons of clarity) by way of an intervening field oxide layer 19 and the epitaxial layer 18 is disposed on a very lightly doped P-type bulk substrate layer 20.

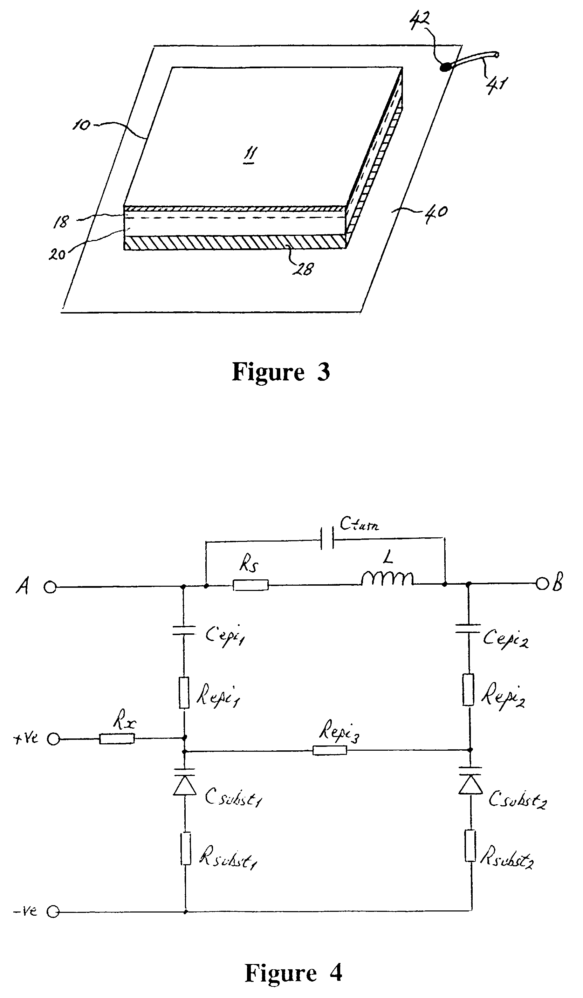

An epitaxial-layer contact 21 is formed from a metallisation pad 22 disposed in the dielectric layer 11. The pad 22 makes an electrical contact with an N+ portion 23 of the epitaxial layer by way of an aperture 24 in the oxide layer 19. An electrical contact is also made with the substrate layer 20 either by means of a special implant or through the chip assembly process. Figure 3 shows one example of a substrate connection in which an integrated circuit (IC) 10 is attached to the metallic base 40 of a package accommodating the IC. The IC comprises a metallisation pattern (not shown) on the dielectric layer 11 which is situated on top of the epitaxial layer 18 and substrate 20. The substrate 20 is attached to the metallic base 40 by way of a conductive epoxy (e.g. silver loaded) layer 28. The bias connection to the substrate 20 is supplied via a conductor 41 connected to the metallic base 40 at a connection point 42.

Forming an enclosure around the inductor structure 12 and epitaxial contact 21 is an isolating structure comprising a trench 25. The trench 25 is etched all the way through the epitaxial layer 18 and into the substrate 20 and encloses an area around the inductor which is large enough to include most of the fringing electric field at the edges of the inductor structure 12.

The advantages of the invention can be seen by reference to Figure 4, which is an equivalent circuit of the inductor arrangement just described.

The inductor structure 12 includes an inductive component L in series with a resistive component Rₛ, these components being shunted by an inter-turn capacitance, Cₜᵤᵣₙ. At a point A on the inductor structure (see Figure 1) there are a number of series-arranged components lying between the inductor metallisation at point B and the substrate 20 below that point. These components are: a capacitance Cₑₚᵢ₁ between the inductor metallisation and the epitaxial layer, a resistance Rₑₚᵢ₁ between the inductor metallisation and the epitaxy-substrate depletion layer, a depletion-layer capacitance C_{subst1} between the epitaxial layer 18 and the substrate 20, and a resistance R_{subst1} between the epitaxial layer 18 and the substrate contact. A similar series arrangement of components exists for the point B, these components being in this case: Cₑₚᵢ₂, Rₑₚᵢ₂, C_{subst2} and R_{subst2}. Finally, there is a resistance Rₑₚᵢ₃ which is the resistance of the epitaxial layer between points A and B at the upper side of the depletion layer 26, and a resistance Rₓ exists between the epitaxial contact pad 22 and point A, this representing the series combination of the resistance of the N+ region 23 and that of the epitaxial layer between the pad 22 and point A. Rₓ is arranged to be large and may, for example, be realised as a resistor.

For areas outside the trench 25, there is a depletion layer 27 which is very shallow due to the fact that the epitaxial layer and the substrate float relative to each other electrically. Within the trench 25, however, by virtue of the application of a reverse-biasing voltage between the epitaxial contact 21 and the corresponding substrate contact 28, 42, the bias voltage having a polarity as shown in Figure 4, the depletion layer is considerably thicker. The depletion layer usually moves mostly into the substrate and only to a limited extent into the epitaxial layer. This is shown in Figure 2 as the depletion layer 26. The total thickness of the depletion layer 26 is roughly proportional to the square root of the magnitude of the reverse-bias voltage.

As a result of this broadening of the depletion layer between the epitaxial layer 18 and the substrate 20, the following advantages are obtained:

Firstly, the depletion-layer capacitances C_{subst1} and C_{subst2} are considerably reduced since the depletion "dielectric" of these capacitances has been made thicker. This in turn reduces the total capacitance existing between the inductor 12 and substrate 20, since C_{subst} appears in series with the fixed Cₑₚᵢ capacitance. Secondly, electric currents induced within the epitaxial layer 18 and the substrate 20 are reduced in magnitude since the cross-sectional area of the epitaxial layer is reduced, hence the epitaxial resistance is increased, and because less energy is coupled into the substrate. In practice, using a reverse bias of 5V, a reduction of the substrate capacitance by a factor of about three can be obtained. This leads to an approximately 50% reduction in total parasitic substrate capacitance as seen by the inductor.

It should be noted that, in the interest of reducing the shunting effect across the substrate capacitances C_{subst1} and C_{subst2}, the resistance Rₓ should have a relatively large impedance.

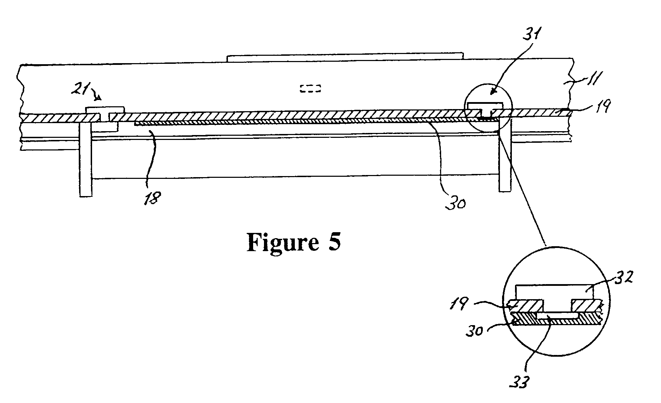

In a second embodiment of the invention, shown in Figure 5 (in which most of the hatching shown in Figure 2 is omitted for reasons of clarity), a further depletion layer is added to the inductor arrangement. This may, for example, be created by the addition of a P-type layer 30 using the base implant mask of the production process. This is a shallow layer which is reverse-biased with respect to the epitaxial layer 18 using the epitaxial contact 21 and a further contact 31 in electrical contact with the upper side of the layer 30. The contact 31, in an analogous manner to the contact 21, comprises a metallisation pad 32 disposed in the dielectric layer 11. The pad makes contact with a P+ low-resistance portion 33 of the P-type layer 30 through an aperture in the oxide layer 19.

This measure results in the creation of a third capacitance in series with the epitaxial layer capacitance and the substrate capacitance with consequent further reduction in overall parasitic capacitance and ohmic energy losses.

It is possible to increase the area contained within the trench 25 in order to capture as much of the inductor's fringing field as possible, thereby allowing as much of the associated parasitic capacitance as possible to be reduced. This is offset, however, by a corresponding increase in substrate capacitance due to the increased surface area of the depletion layer 26 (and also the depletion layer 30 in the second embodiment).

## Claims

1. An integrated inductor arrangement, comprising a first layer of a first doping type disposed on a second layer of a second doping type, a dielectric layer disposed on said first layer and a metallisation inductor structure disposed on said dielectric layer, a biasing means being provided to allow the reverse-biasing of said first layer with respect to said second layer.

2. An integrated inductor arrangement as claimed in Claim 1, comprising a field oxide layer disposed between said dielectric layer and said first layer.

3. An integrated inductor arrangement as claimed in Claim 2, in which the biasing means comprises a first contact structure disposed in said dielectric layer adjacent said oxide layer and making electric contact with said first layer, and a second contact structure in electrical contact with said second layer.

4. An integrated inductor arrangement as claimed in Claim 3, in which said first contact structure is a high-impedance contact structure.

5. An integrated inductor arrangement as claimed in Claim 4, comprising a further layer of said second doping type disposed in said first layer adjacent said oxide layer, a further biasing means being provided to allow the reverse-biasing of said further layer with respect to said first layer.

6. An integrated inductor arrangement as claimed in Claim 5, in which said further biasing means comprises a third contact structure of said second doping type in electrical contact with a surface of said further layer adjacent said oxide layer.

7. An integrated inductor arrangement as claimed in Claim 6, in which said third contact structure is a high-impedance contact structure.

8. An integrated inductor arrangement as claimed in any one of Claim 5 to 7, in which said further layer is a shallow implant.

9. An integrated inductor arrangement as claimed in any one of Claims 5 to 7, in which said further layer is a deposited layer.

10. An integrated inductor arrangement as claimed in any one of the preceding claims, in which the first layer is an epitaxial layer and the second layer is a substrate layer.

11. An integrated inductor arrangement as claimed in Claim 10, comprising an isolating structure for isolating the inductor structure from other circuitry on said substrate layer.

12. An integrated inductor arrangement as claimed in Claim 11, in which said isolating structure comprises a trench etched through said epitaxial layer into said substrate layer and disposed such as to enclose an area containing most of the fringing electric fields which are produced by the inductor stucture during use.
